# EUROPEAN PATENT APPLICATION

(11) **EP 4 815 650 A1**
(43) Date of publication of application: **30.09.2026**
(21) Application number: 26158123.5
(22) Date of filing: 12.02.2026
(51) Int. Cl.: H05K 7/14

(54) **SUPPORTING DEVICE**

(30) Priority: 25.03.2025 TW 114111635
(71) Applicant: King Slide Works Co., Ltd., Kaohsiung City 821010 (TW); King Slide Technology Co., Ltd., Kaohsiung City 821011 (TW)
(72) Inventor: CHEN, Ken-Ching, 821010 Kaohsiung City (TW); YANG, Shun-Ho, 821010 Kaohsiung City (TW); CHEN, Yao-Tsung, 821010 Kaohsiung City (TW); WANG, Chun-Chiang, 821010 Kaohsiung City (TW)
(74) Representative: Viering, Jentschura & Partner mbB Patent- und Rechtsanwälte

(57) **Abstract**

A supporting device (20, 200) includes a supporting member (22, 202), a fastening member (24, 204), an operating member (28, 208) and a retaining member (26, 206). The fastening member (24, 204) includes an elastic part (48, 212) and a locking part (50, 214) . The locking part (50, 214) is configured to be extended from a first side of the supporting member (22, 202) and protruded relative to a second side of the supporting member (22, 202) to be in a locking state. When the operating member (28, 208) is moved from a first position to a second position, the locking part (50, 214) is moved from the second side toward the first side of the supporting member (22, 202) to switch from the locking state to an unlocking state, and the retaining member (26, 206) is configured to hold the locking part (50, 214) in the unlocking state.

## Description

### Field of the Invention

The present invention is related to a supporting device.

### Background of the Invention

U.S. patent number US 8,127,940 B2 discloses a support structure for supporting an information handling system. FIG. 2 of the aforementioned patent discloses a support structure mounted to a rack and configured to support a carried object (such as a chassis). The support structure comprises a guide slot extended along a longitudinal length direction of a slide rail. An opening of the guide slot is adjacent to a front end of the support structure in order to allow a guide structure of the carried object to pass through the guide slot for supporting the carried object. When the guide structure passes through the guide slot to support the carried object, there is no structure configured to lock the carried object. Therefore, the carried object cannot be stably held on the support structure.

U.S. patent number US 10,869,404 B2 discloses a server device and its latch mechanism. The server device comprises a server rack and a chassis. The server rack comprises an internal space, a first sliding rail, a second sliding rail and a fixing hole. The first sliding rail and the second sliding rail are oppositely arranged in the internal space. The fixing hole is formed on the first sliding rail. The chassis is removably received in the internal space and slidably located on the first sliding rail and the second sliding rail. The latch mechanism is fixedly disposed on the chassis, and configured to lock or unlock the chassis.

Although US 10,869,404 B2 teaches that the chassis can be locked, the latch mechanism fixed to the chassis will reduce installation space inside the chassis available for electronic devices, so as to increase difficulty for installing the electronic devices within the limited space inside the chassis. Therefore, for different market requirements, it is important to develop various products.

### Summary of the Invention

This in mind, the present invention aims at providing a supporting device.

This is achieved by a supporting device according to claim 1. The dependent claims pertain to corresponding further developments and improvements.

As will be seen more clearly from the detailed description following below, the claimed supporting device comprises a supporting member, a fastening member, an operating member and a retaining member. The supporting member has a first side and a second side opposite to the first side. The fastening member is arranged on the supporting member. The fastening member comprises an elastic part and a locking part. The locking part is configured to be extended from the first side of the supporting member to be protruded relative to the second side of the supporting member in response to an elastic force provided by the elastic part in order to be in a locking state. The operating member is operatively connected to the fastening member. The retaining member is arranged on the supporting member. When the operating member is operated to move from a first position to a second position relative to the supporting member, the locking part of the fastening member is configured to be moved from the second side of the supporting member toward the first side of the supporting member to switch from the locking state to an unlocking state, and the retaining member is configured to be detachably engaged with one of the fastening member and the operating member in order to hold the locking part of the fastening member in the unlocking state.

### Brief Description of the Drawings

In the following, the invention is further illustrated by way of example, taking reference to the accompanying drawings thereof:
FIG. 1 is a diagram showing a pair of supporting devices mounted to a rack according to a first embodiment of the present invention;
FIG. 2 is a diagram showing the pair of supporting devices according to the first embodiment of the present invention;
FIG. 3 is an exploded view of the supporting device according to the first embodiment of the present invention;
FIG. 4 is an enlarged view of an area A of FIG. 3;
FIG. 5 is a diagram showing an operating member of the supporting device being located at a first position according to the first embodiment of the present invention;
FIG. 6 is a diagram showing the operating member of the supporting device being located at the first position from another viewing angle according to the first embodiment of the present invention;
FIG. 7 is an enlarged view of an area B of FIG. 6;
FIG. 8 is an enlarged view of an area C of FIG. 6;
FIG. 9 is a diagram showing the operating member of the supporting device being located at a second position according to the first embodiment of the present invention;
FIG. 10 is a diagram showing the operating member of the supporting device being located at the second position from another viewing angle according to the first embodiment of the present invention;
FIG. 11 is an enlarged view of an area D of FIG. 10;
FIG. 12 is an enlarged view of an area E of FIG. 10;
FIG. 13 is a diagram showing the supporting device carrying a carried object according to the first embodiment of the present invention;
FIG. 14 is a diagram showing the supporting device carrying a carried object with the carried object being in a retracted state according to the first embodiment of the present invention;
FIG. 15 is a diagram showing the supporting device carrying the carried object with the carried object being in the retracted state from another viewing angle according to the first embodiment of the present invention;
FIG. 16 is a diagram showing the supporting device carrying the carried object with the carried object being moved along an opening direction according to the first embodiment of the present invention;
FIG. 17 is a diagram showing a supporting device with an operating member being located at a first position according to a second embodiment of the present invention; and
FIG. 18 is a diagram showing the supporting device with the operating member being located at a second position according to the second embodiment of the present invention.

### Detailed Description

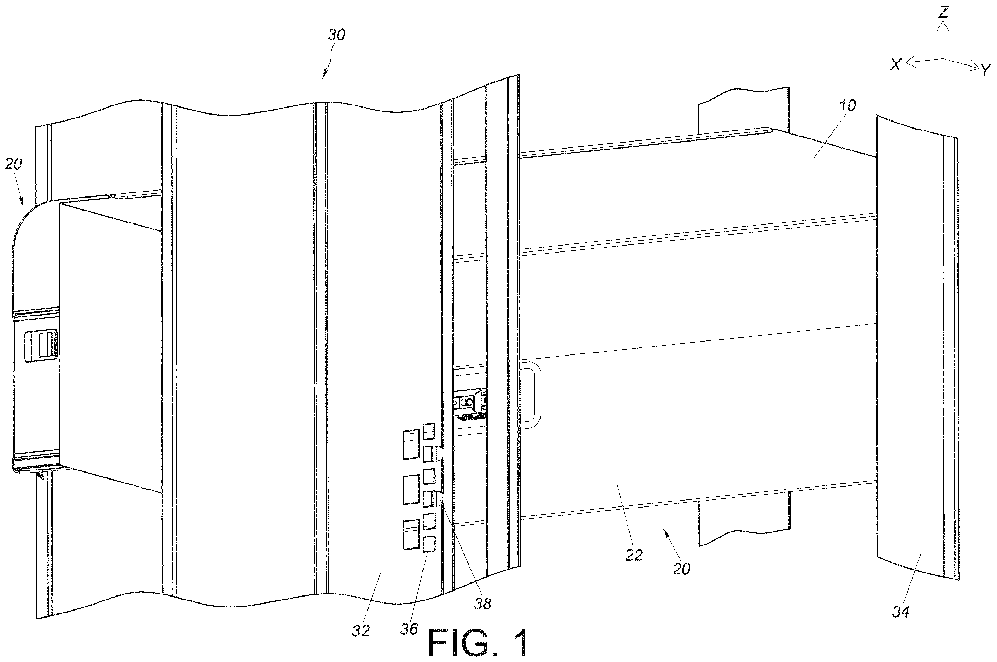

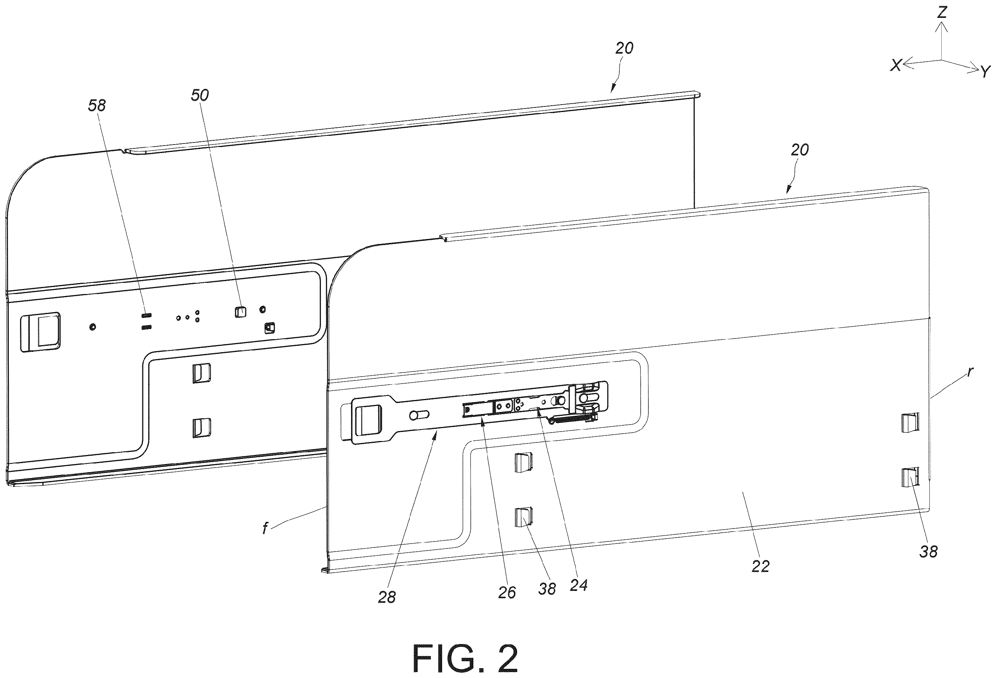

As shown in FIG. 1 and FIG. 2, a pair of supporting devices 20 are configured to support a carried object 10 according to a first embodiment of the present invention. Each of the supporting devices 20 comprises a supporting member 22, a fastening member 24, a retaining member 26, and an operating member 28. The supporting members 22 are configured to be mounted to left and right sides of a rack 30 respectively. The left and right sides of the rack 30 have substantially identical structural configuration. For simplicity, only one side (such as the right side) is described below. The right side of the rack 30 is provided with at least one post. In the present embodiment, the right side of the rack 30 is provided with a first post 32 (such as a front post) and a second post 34 (such as a rear post) . The first post 32 is formed with a plurality of mounting holes 36 arranged along a height direction of the first post 32 and spaced apart from each other. The mounting hole 36 is defined by a plurality of wall sections. The second post 34 has the same configuration as the first post 32. The supporting member 22 has a front end f and a rear end r, and each of the front end f and the rear end r comprises at least one mounting part 38. The mounting part 38 can be a hook. The mounting parts 38 of the front end f and the rear end r of the supporting member 22 are configured to be correspondingly mounted to the mounting holes 36 of the first post 32 and the second post 34 respectively, so as to fix the supporting device 20 to the rack 30, but the present invention is not limited thereto. In the present embodiment, the X axis is a longitudinal direction (or a length direction) of the supporting device, the Y axis is a transverse direction (or a lateral direction) of the supporting device, and the Z axis is a vertical direction (or a height direction) of the supporting device.

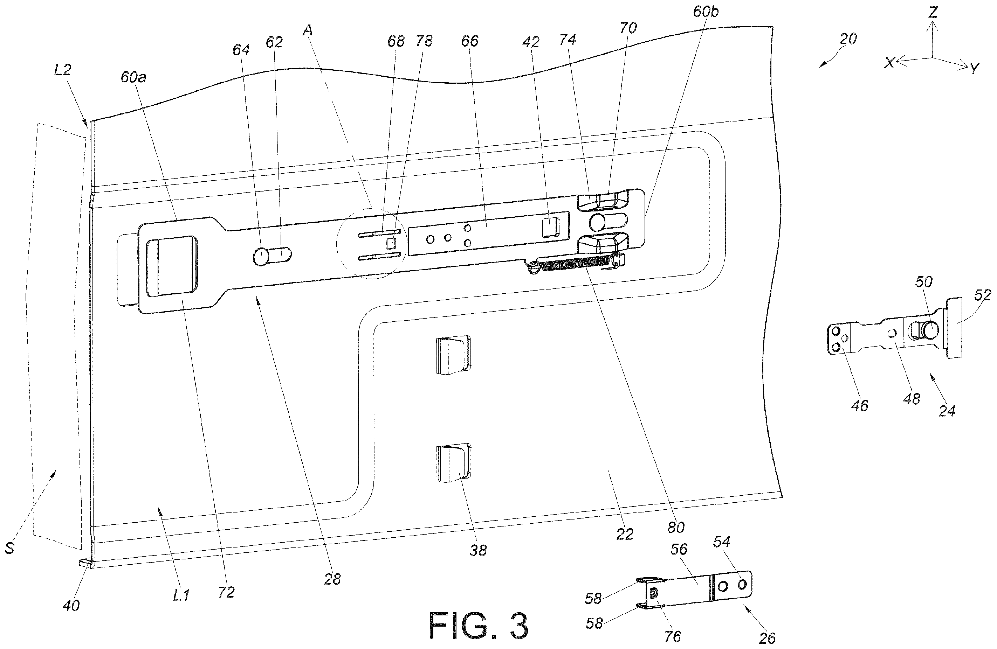

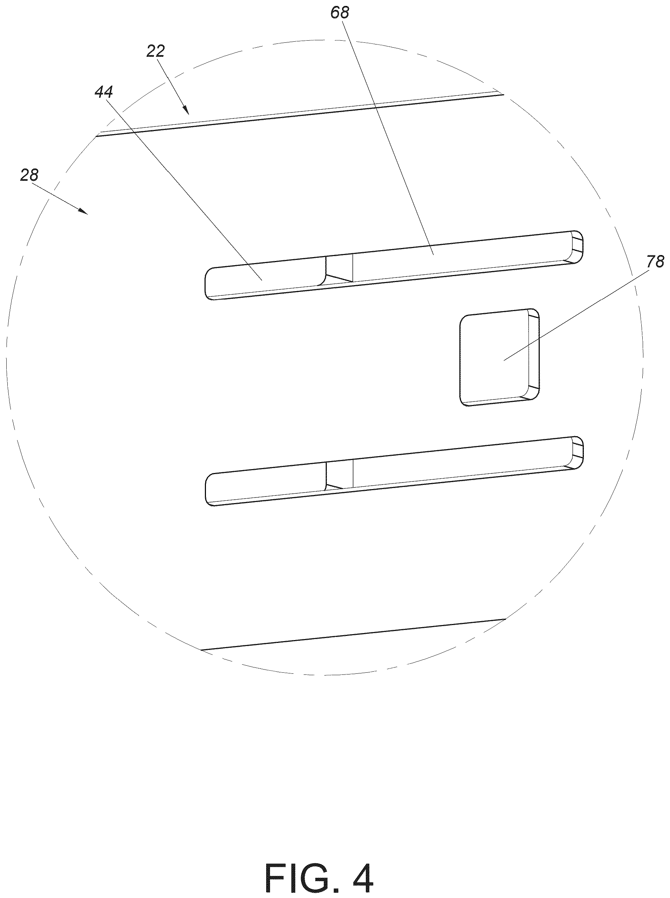

As shown in FIG. 3 and FIG. 4, the supporting member 22 has a first side L1 (such as an outer side) and a second side L2 (such as an inner side) opposite to the first side L1. The supporting member 22 is arranged with a supporting part 40 perpendicularly connected to the supporting member 22. The second side L2 of the supporting member 22 and the support part 40 together define a carrying space S and configured to carry the carried object 10 (please also refer to FIG. 1). The supporting member 22 is formed with a first opening 42 and a second opening 44, and each of the first opening 42 and the second opening 44 is communicated with the first side L1 and the second side L2 of the supporting member 22. Each of the first opening 42 and the second opening 44 is defined by a plurality of wall sections. In the present embodiment, the supporting member 22 is formed with two second openings 44, but the present invention is not limited thereto.

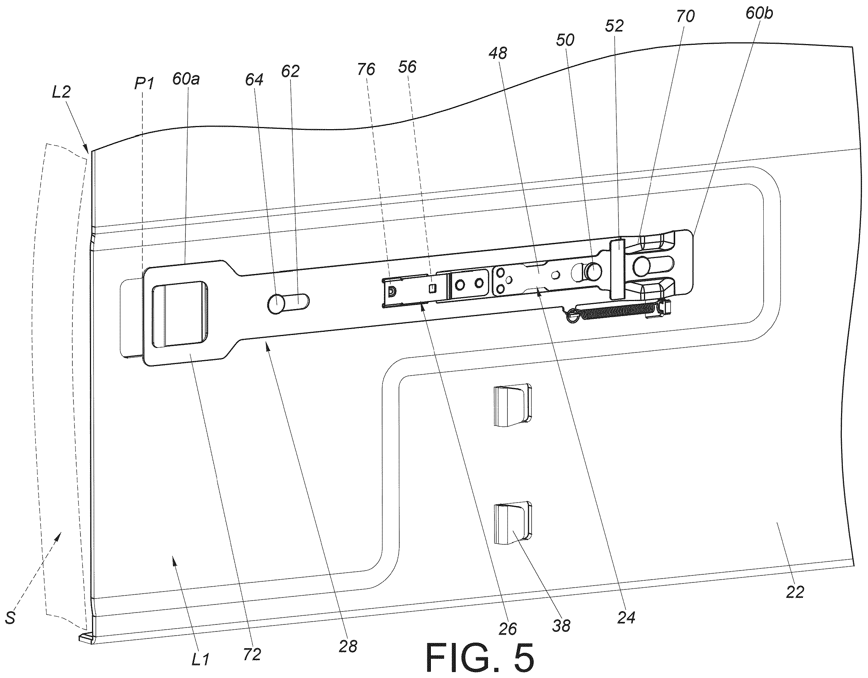

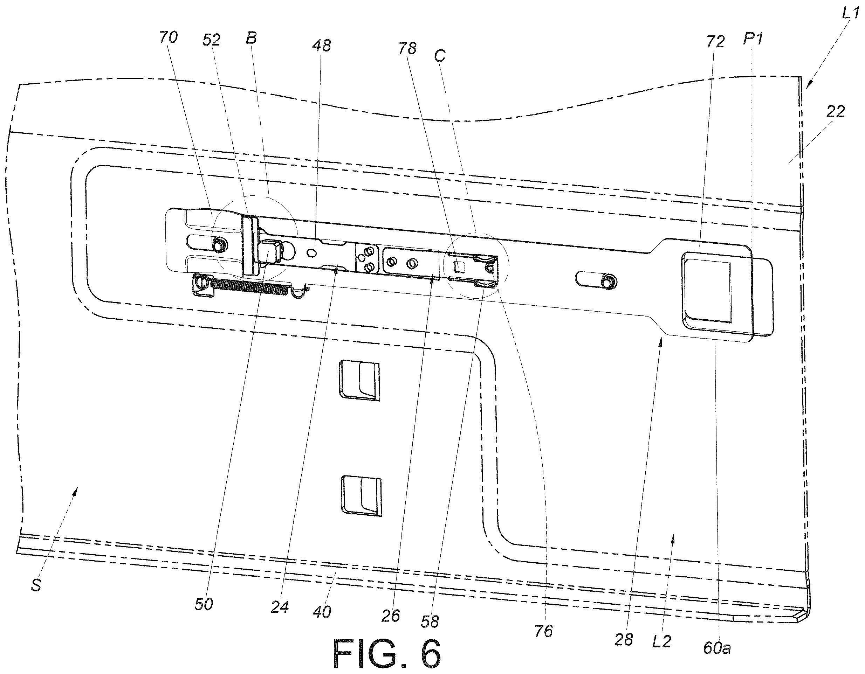

The fastening member 24 is arranged on the supporting member 22. For example, the fastening member 24 is arranged on the first side L1 of the supporting member 22. The fastening member 24 can be an elastic object (such as a spring sheet), but the present invention is not limited to thereto. The fastening member 24 comprises a fixing part 46 and an elastic part 48 extended from the fixing part 46. The fixing part 46 is connected (such as fixed, riveted, or welded) to the first side L1 of the supporting member 22, and the elastic part 48 is arranged with a locking part 50. The locking part 50 can be a protrusion connected to (e.g., fixed to or engaged with) the elastic part 48, or the locking part 50 can be a protrusion integrally formed on the elastic part 48. For example, the locking part 50 is extended from the elastic part 48 along the transverse direction from the first side L1 of the supporting member 22 toward the second side L2 of the supporting member 22 (please also refer to FIG. 5 and FIG. 6).

Preferably, the locking part 50 corresponds to the first opening 42 of the supporting member 22, and the locking part 50 is configured to be extended from the first side L1 of the supporting member 22 to be protruded relative to the second side L2 of the supporting member 22 through the first opening 42 of the supporting member 22 in response to an elastic force provided by the elastic part 48 (please also refer to FIG. 6).

Preferably, the fastening member 24 further comprises an abutting feature 52 adjacent to the locking part 50. The abutting feature 52 can be in a sheet shape, but the present invention is not limited thereto.

The retaining member 26 is arranged on the supporting member 22. For example, the retaining member 26 is arranged on the first side L1 of the supporting member 22 and adjacent to the fastening member 24. The retaining member 26 can be an elastic object (such as a spring sheet), but the present invention is not limited thereto. The retaining member 26 comprises a connecting part 54 and an elastic arm 56 extended from the connecting part 54. The connecting part 54 is connected (such as fixedly connected, riveted, or welded) to the first side L1 of the supporting member 22. The elastic arm 56 is arranged with at least one disengaging part 58. The disengaging part 58 can be a protrusion connected (such as fixedly connected) to the elastic arm 56 (or the disengaging part 58 can be a protrusion integrally formed on the elastic arm 56), but the present invention is not limited thereto. In the present embodiment, the disengaging part 58 is configured to be extended from the first side L1 of the supporting member 22 to be protruded relative to the second side L2 of the supporting member 22 in response to an elastic force provided by the elastic arm 56. For example, two disengaging parts 58 are extended from the elastic arm 56 along the transverse direction from the first side L1 of the supporting member 22 toward the second side L2 of the supporting member 22 (please also refer to FIG. 5 and FIG. 6). The disengaging part 58 can be formed with an inclined surface or an arc surface, but the present invention is not limited thereto.

Preferably, the disengaging part 58 corresponds to the second opening 44 of the supporting member 22, and the disengaging part 58 is configured to be extended from the first side L1 of the supporting member 22 to be protruded relative to the second side L2 of the supporting member 22 through the second opening 44 of the supporting member 22 in response to the elastic force provided by the elastic arm 56 (please also refer to FIG. 6).

The operating member 28 is operatively connected to the fastening member 24. For example, the operating member 28 is movably arranged on the first side L1 of the supporting member 22. The operating member 28 can be an elongated body or a rod body having a predetermined longitudinal length, and the operating member 28 has a front end part 60a and a rear end part 60b opposite to each other. The operating member 28 and the supporting member 22 have limiting features corresponding to each other. The limiting features is arranged adjacent to the front end part 60a or the rear end part 60b of the operating member 28, but the present invention is not limited thereto. For example, the operating member 28 is formed with at least one longitudinal hole 62 as one of the limiting features, and the supporting member 22 is arranged with a protruding member 64 (such as a nail or a pin) as the other one of the limiting features connected (such as fixedly connected) to the first side L1 of the supporting member 22 by passing through the longitudinal hole 62. Accordingly, the operating member 28 is longitudinally movable within a limited range relative to the supporting member 22.

Preferably, the operating member 28 is formed with a longitudinal elongated hole 66 corresponding to and communicating with the first opening 42 of the supporting member 22, and a guiding hole 68 corresponding to and communicating with the second opening 44 of the supporting member 22. During longitudinal movement of the operating member 28 relative to the supporting member 22, the longitudinal elongated hole 66 keeps communicating with the first opening 42 and the guiding hole 68 keeps communicating with the second opening 44, but the present invention is not limited thereto.

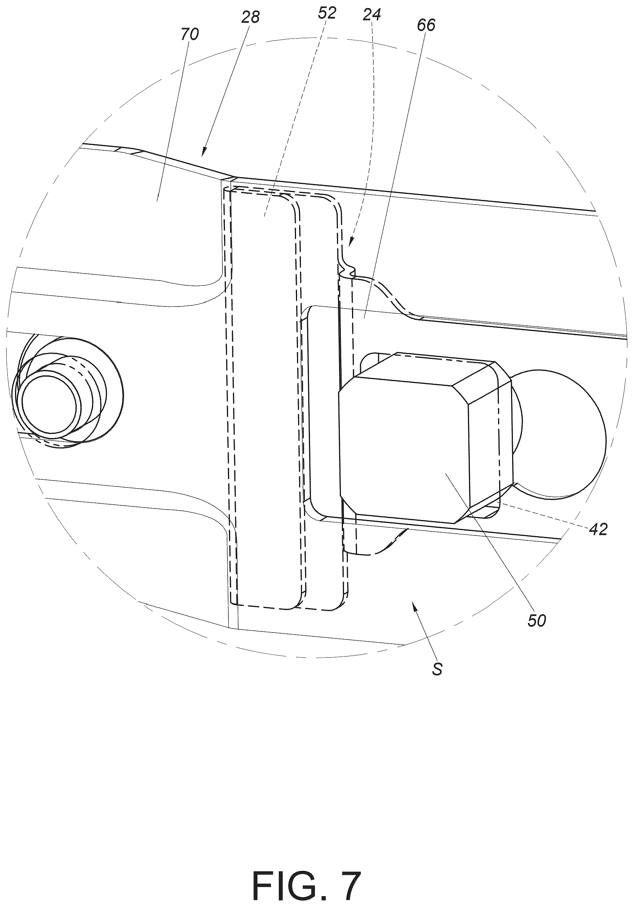

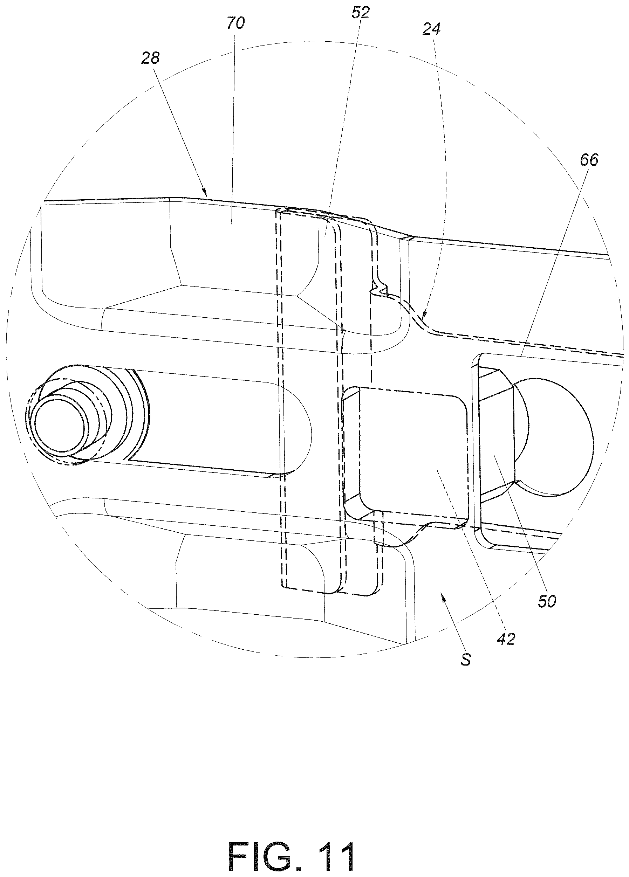

Preferably, the operating member 28 comprises a guiding part 70 and an operating part 72 respectively arranged at the rear end part 60b and the front end part 60a of the operating member 28, and the fastening member 24 and the retaining member 26 are arranged adjacent to each other and located adjacent to the rear end part 60b of the operating member 28. In the present embodiment, the guiding part 70 of the operating member 28 corresponds to the abutting feature 52 of the fastening member 24, such that when the operating member 28 is operated to moved, the guiding part 70 of the operating member 28 is configured to abut against the abutting feature 52 of the fastening member 24 in order to drive the locking part 50 of the fastening member 24 to move to change its state (please also refer to FIG. 7 and FIG. 11). The guiding part 70 of the operating member 28 has at least one guiding section 74 extended outward. The guiding part 70 can be formed with an inclined surface or an arc surface, but the present invention is not limited thereto.

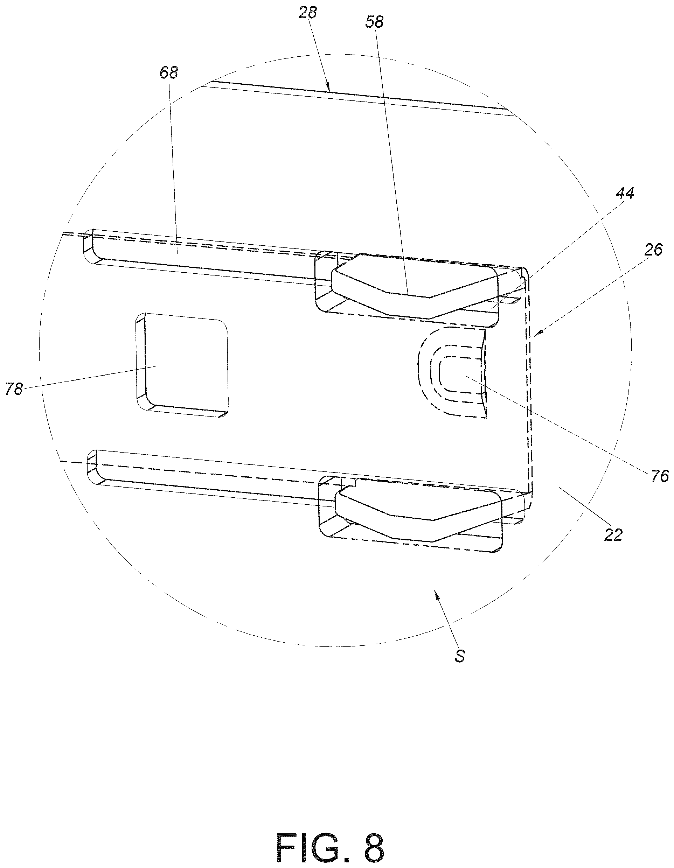

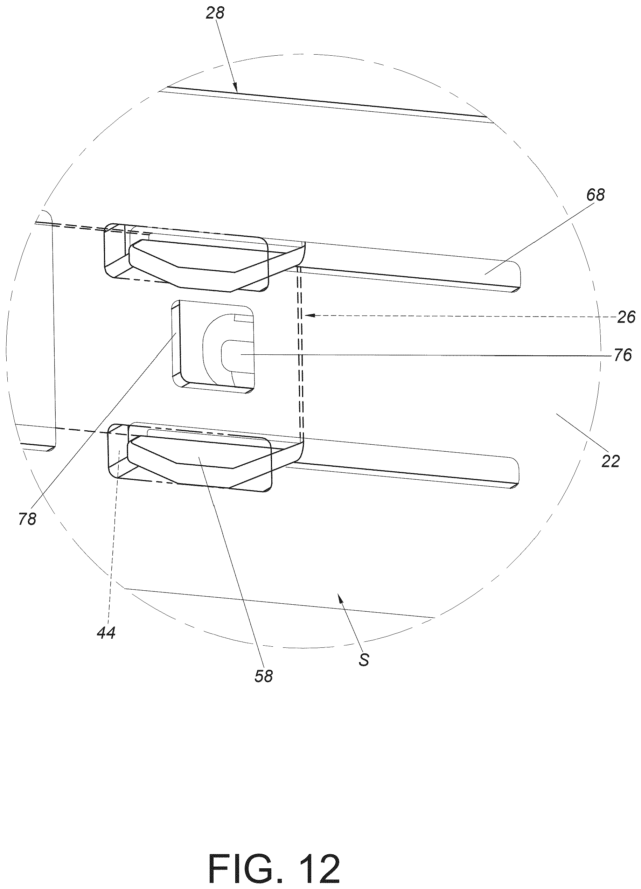

Preferably, the operating member 28 is configured to be engaged with the retaining member 26 when the operating member 28 is operated to move, such that the operating member 28 and the fastening member 24 are held in a holding state. In the present embodiment, the retaining member 26 comprises a blocking part 76 (such as a stopping block or a protrusion block) and the operating member 28 comprises an engaging feature 78 (such as a groove or an opening), but the present invention is not limited thereto. For example, the blocking part 76 can be arranged on one of the retaining member 26 and the operating member 28, and the engaging feature 78 can be arranged on the other one of the retaining member 26 and the operating member 28. During a process of operating the operating member 28 to move, the blocking part 76 of the retaining member 26 is configured to fall into or engage with the engaging feature 78 of the operating member 28 (please refer to FIG. 8 and FIG. 12).

Preferably, the operating member 28 and the retaining member 26 can be disengaged from each other by the disengaging part 58 of the retaining member 26. For example, by pushing or applying an external force to the disengaging part 58 of the retaining member 26, the operating member 28 can be disengaged from the retaining member 26, but the present invention is not limited thereto.

The supporting device 20 further comprises a return elastic member 80 configured to provide an elastic force to the operating member 28. In the present embodiment, two ends of the return elastic member 80 are connected to the supporting member 22 and the operating member 28 respectively.

As shown in FIG. 5 to FIG. 8, when the operating member 28 is located at a first position P1, the abutting feature 52 of the fastening member 24 and the guiding part 70 of the operating member 28 do not abut against each other, such that the locking part 50 of the fastening member 24 is extended from the first side L1 of the supporting member 22 to be protruded relative to the second side L2 of the supporting member 22 in response to the elastic force provided by the elastic part 48 to be in a locking state, and the blocking part 76 of the retaining member 26 and the engaging feature 78 of the operating member 28 are not engaged with each other. Meanwhile, the disengaging part 58 of the retaining member 26 is configured to be extended from the first side L1 of the supporting member 22 to be protruded relative to the second side L2 of the supporting member 22 in response to the elastic force provided by the elastic arm 56.

Preferably, when the operating member 28 is located at the first position P1 relative to the supporting member 22, the locking part 50 of the fastening member 24 is configured to be extended from the first side L1 of the supporting member 22 to be protruded relative to the second side L2 of the supporting member 22 in response to the elastic force provided by the elastic part 48, so as to pass through the longitudinal elongated hole 66 of the operating member 28 to extend into the carrying space S from the first opening 42 of the supporting member 22 to be in the locking state (as shown in FIG. 6 and FIG. 7), and the blocking part 76 of the retaining member 26 and the engaging feature 78 of the operating member 28 are not engaged with each other. Meanwhile, the disengaging part 58 of the retaining member 26 is configured to be extended from the first side L1 of the supporting member 22 to be protruded relative to the second side L2 of the supporting member 22 in response to the elastic force provided by the elastic arm 56, so as to pass through the guiding hole 68 of the operating member 28 to extend into the carrying space S from the second opening 44 of the supporting member 22 (as shown in FIG. 6 and FIG. 8).

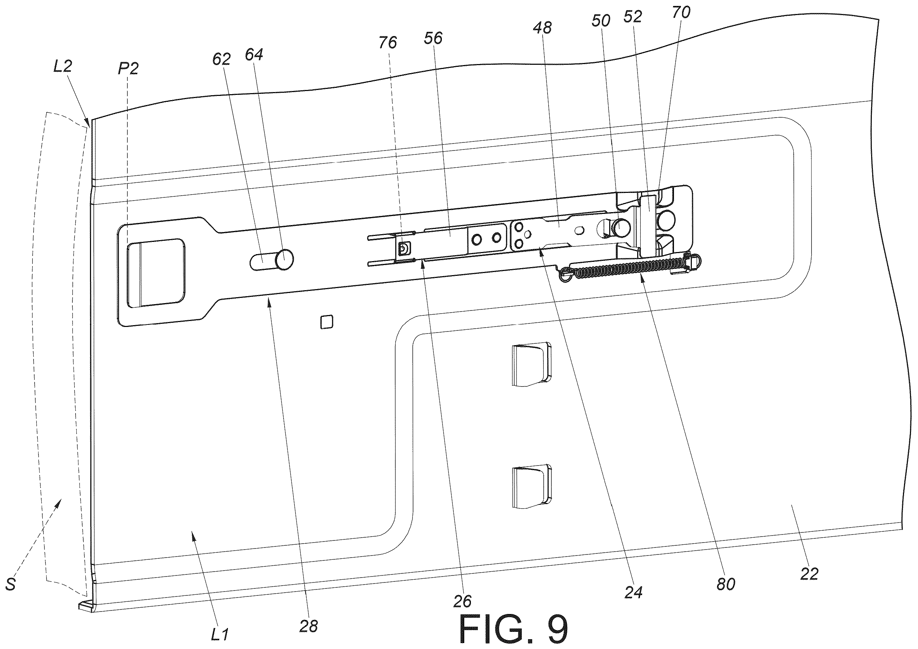

As shown in FIG. 9 to FIG. 12, when the operating member 28 is operated to move from the first position P1 to a second position P2 relative to the supporting member 22, the abutting feature 52 of the fastening member 24 and the guiding part 70 of the operating member 28 are configured to abut against each other, such that the locking part 50 of the fastening member 24 is moved from the second side L2 of the supporting member 22 toward the first side L1 of the supporting member 22 to be moved away (or retracted) from the carrying space S to be in an unlocking state, and the blocking part 76 of the retaining member 26 and the engaging feature 78 of the operating member 28 are engaged with each other, such that the operating member 28 is temporarily held at the second position P2, so as to hold the locking part 50 of the fastening member 24 in the unlocking state. Since the abutting feature 52 of the fastening member 24 and the guiding part 70 of the operating member 28 abut against each other, the elastic part 48 of the fastening member 24 is configured to accumulate an elastic force. Meanwhile, the disengaging part 58 of the retaining member 26 is configured to be extended from the first side L1 of the supporting member 22 to be protruded relative to the second side L2 of the supporting member 22 in response to the elastic force generated by the elastic arm 56.

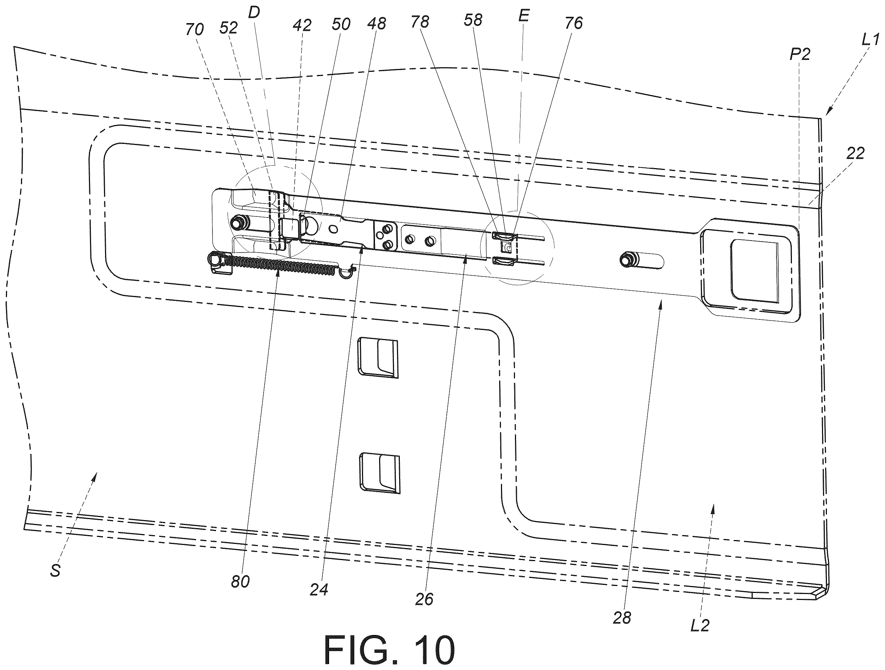

Preferably, when the operating member 28 is operated to move from the first position P1 to a second position P2 relative to the supporting member 22, the locking part 50 of the fastening member 24 is configured to be moved from the second side L2 of the supporting member 22 toward the first side L1 of the supporting member 22 to be moved away (or retracted) from the carrying space S, so as to be retracted relative to the second side L2 of the supporting member 22 through the longitudinal elongated hole 66 of the operating member 28 and the first opening 42 of the supporting member 22 to be in the unlocking state (as shown in FIG. 10 and FIG. 11). Moreover, the blocking part 76 of the retaining member 26 and the engaging feature 78 of the operating member 28 are configured to be engaged with each other, such that the operating member 28 is temporarily held at the second position P2, so as to hold the locking part 50 of the fastening member 24 in the unlocking state. Since the abutting feature 52 of the fastening member 24 and the guiding part 70 of the operating member 28 abut against each other, the elastic part 48 of the fastening member 24 is configured to accumulate an elastic force. Meanwhile, the disengaging part 58 of the retaining member 26 is configured to be extended from the first side L1 of the supporting member 22 to be protruded relative to the second side L2 of the supporting member 22 in response to the elastic force provided by the elastic arm 56, so as to pass through the guiding hole 68 of the operating member 28 to extend into the carrying space S from the second opening 44 of the supporting member 22 (as shown in FIG. 10 and FIG. 12). Meanwhile, the return elastic member 80 is in a state of accumulating the elastic force to be provided to the operating member 28.

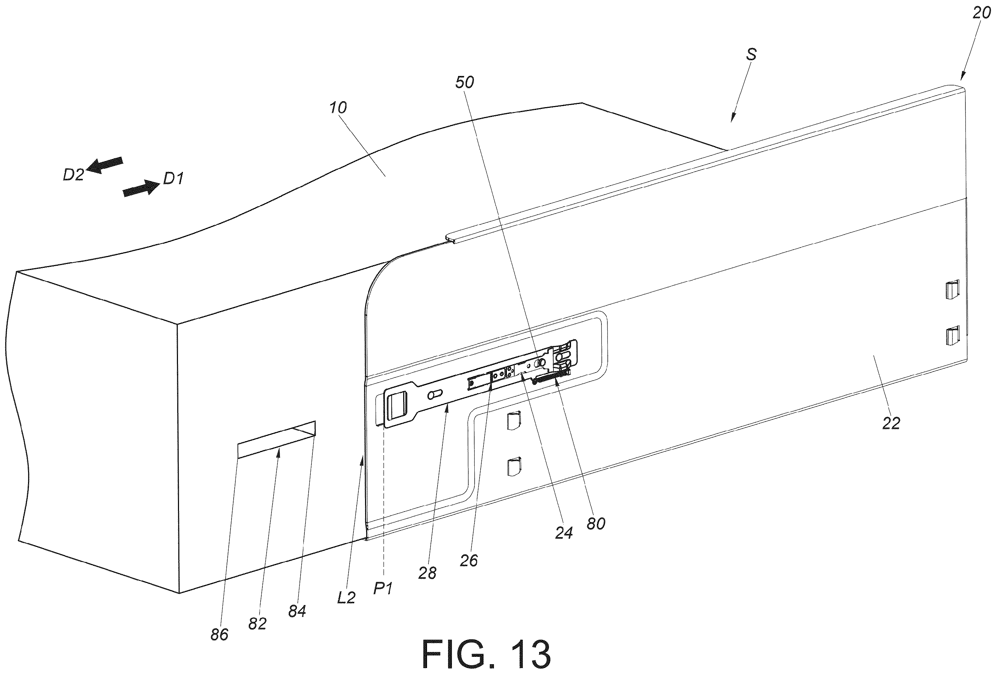

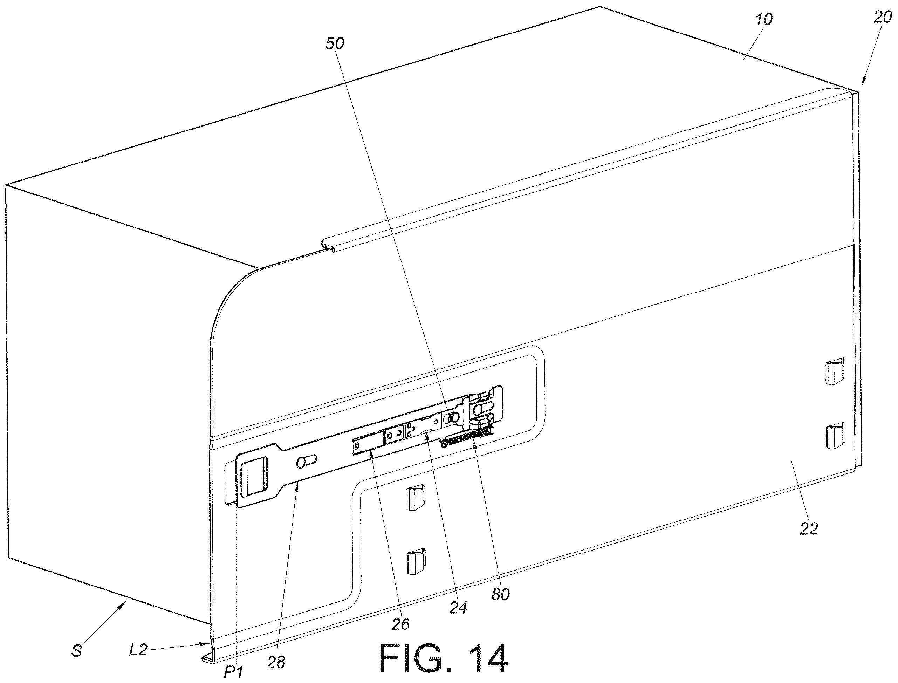

As shown in FIG. 13 to FIG. 15, the carried object 10 comprises a stopping feature 82, and the carried object 10 is longitudinally movable relative to the supporting member 22. For example, the stopping feature 82 of the carried object 10 is arranged on a lateral side of the carried object 10 facing toward the second side L2 of the supporting member 22. When the carried object 10 is retracted relative to the supporting member 22 (as shown in FIG. 14), the stopping feature 82 of the carried object 10 corresponds to the locking part 50 of the fastening member 24 and the disengaging part 58 of the retaining member 26. The stopping feature 82 of the carried object 10 comprises a first stopping section 84 and a second stopping section 86. The stopping feature 82 can be formed with a longitudinal opening (or groove), but the present invention is not limited thereto.

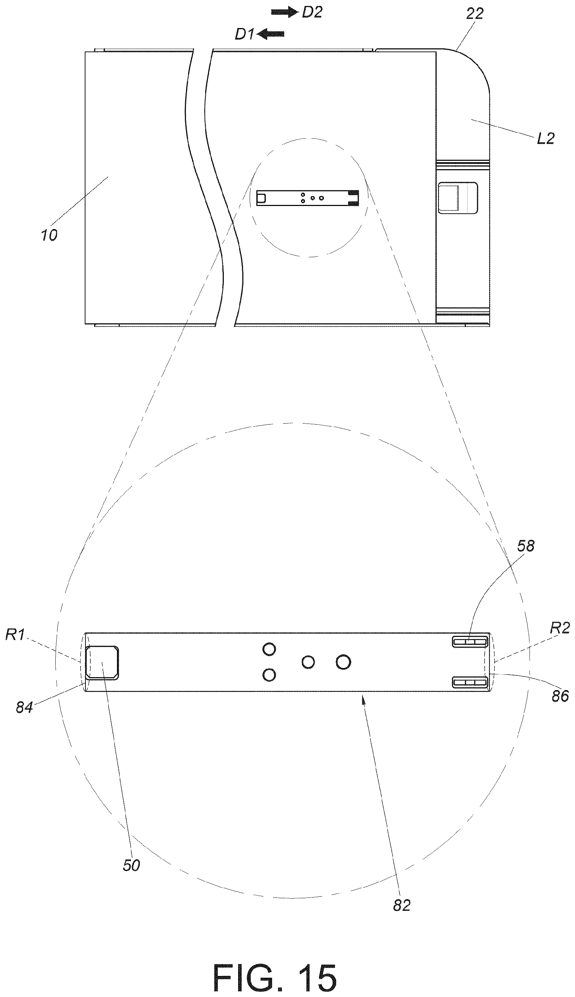

Preferably, when the carried object 10 is moved along a retracting direction D1 to be retracted relative to the supporting member 22 (as shown in FIG. 14), the first stopping section 84 of the stopping feature 82 of the carried object 10 corresponds to the locking part 50 of the fastening member 24, and the second stopping section 86 of the stopping feature 82 of the carried object 10 corresponds to the disengaging part 58 of the retaining member 26 (as shown in FIG. 15). When the locking part 50 of the fastening member 24 is in the locking state, the locking part 50 of the fastening member 24 is protruded relative to the second side L2 of the supporting member 22 to be extended toward the stopping feature 82 of the carried object 10, so as to form a first stopping mechanism R1. In addition, when the disengaging part 58 of the retaining member 26 is protruded relative to the second side L2 of the supporting member 22, the disengaging part 58 of the retaining member 26 is extended toward the stopping feature 82 of the carried object 10, so as to form a second stopping mechanism R2 (as shown in FIG. 15).

Preferably, when the first stopping mechanism R1 formed by the locking part 50 of the fastening member 24 and the first stopping section 84 of the stopping feature 82 of the carried object 10 is enabled, the locking part 50 of the fastening member 24 and the first stopping section 84 of the stopping feature 82 of the carried object 10 are configured to block each other; and when the second stopping mechanism R2 formed by the disengaging part 58 of the retaining member 26 and the second stopping section 86 of the stopping feature 82 of the carried object 10 is enabled, the disengaging part 58 of the retaining member 26 and the second stopping section 86 of the stopping feature 82 of the carried object 10 are configured to block each other. As such, the carried object 10 is prevented from being longitudinally moved relative to the supporting member 22 along the retracting direction D1 or an opening direction D2.

When the operating member 28 is located at the first position P1 and when the carried object 10 is retracted relative to the supporting member 22, the locking part 50 of the fastening member 24 and the disengaging part 58 of the retaining member 26 correspond to the stopping feature 82 of the carried object 10, so as to enable the first stopping mechanism R1 and the second stopping mechanism R2, such that the carried object 10 is prevented from being longitudinally moved relative to the supporting member 22.

When a user is going to detach the carried object 10 from the supporting member 22 to perform replacement or maintenance operations, the user is required to operate the operating member 28 to move from the first position P1 to the second position P2 (as shown in FIG. 9 and FIG. 10) . Accordingly, the abutting feature 52 of the fastening member 24 and the guiding part 70 of the operating member 28 are configured to abut against each other, such that the locking part 50 of the fastening member 24 is moved from the second side L2 of the supporting member 22 toward the first side L1 of the supporting member 22 to be moved away (or retracted) from the carrying space S, so as to be retracted relative to the second side L2 of the supporting member 22 through the longitudinal elongated hole 66 of the operating member 28 and the first opening 42 of the supporting member 22 to be in the unlocking state (as shown in FIG. 11). Meanwhile, the first stopping mechanism R1 is disabled (the locking part 50 of the fastening member 24 and the first stopping section 84 of the stopping feature 82 of the carried object 10 no longer block each other), and the elastic part 48 of the fastening member 24 is configured to accumulate the elastic force. In addition, the blocking part 76 of the retaining member 26 and the locking feature 78 of the operating member 28 are configured to be engaged with each other to temporarily hold the operating member 28 at the second position P2. As such, the user can remove the carried object 10 from the carrying space S to detach the carried object 10 from the supporting member 22 by longitudinally moving the carried object 10 relative to the supporting member 22 along the opening direction D2.

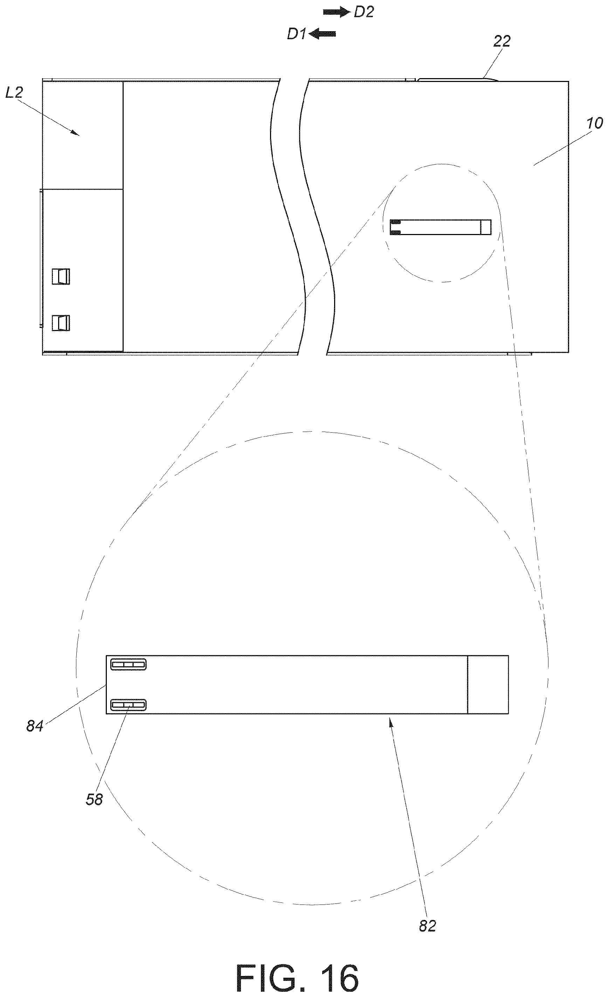

As shown in FIG. 16, during a process of longitudinally moving the carried object 10 relative to the supporting member 22 along the opening direction D2 to detach the carried object 10 from the supporting member 22, the disengaging part 58 of the retaining member 26 is configured to be moved to disable the second stopping mechanism R2. In the present embodiment, the disengaging part 58 of the retaining member 26 is configured to be pushed by the first stopping section 84 of the stopping feature 82 of the carried object 10 to be moved away from the stopping feature 82, so as to disengage the blocking part 76 of the retaining member 26 from the engaging feature 78 of the operating member 28 accordingly, such that the operating member 28 is moved to the first position P1 from the second position P2 in response to the elastic force released by the elastic part 48 of the fastening member 24 in order to allow the locking part 50 of the fastening member 24 to move toward the carrying space S to switch from the unlocking state to the locking state (please also refer to FIG. 5 and FIG. 6). In order to push the disengaging part 58 of the retaining member 26 to move to disable the second stopping mechanism R2, at least one of the disengaging part 58 of the retaining member 26 and the first stopping section 84 of the stop feature 82 of the carried object 10 has a guiding section (in the present embodiment, the disengaging part 58 of the retaining member 26 is formed with a inclined surface as the guiding section). Such configuration is well known to those skilled in the art, for simplification, no further illustration is provided.

Preferably, when the blocking part 76 of the retaining member 26 and the engaging feature 78 of the operating member 28 are disengaged from each other, the return elastic member 80 is configured to provide the elastic force to the operating member 28, to ensure that the operating member 28 is moved from the second position P2 to the first position P1, in order to allow the locking part 50 of the fastening member 24 to move toward the carrying space S to switch from the unlocking state to the locking state.

During the process of the user longitudinally moving the carried object 10 relative to the supporting member 22 along the retracting direction D1 for mounting the carried object 10 to the rack 30 through the supporting member 22 with the operating member 28 being located at the first position P1 (as shown in FIG. 13), the locking part 50 of the fastening member 24 is configured to be in the locking state (as shown in FIG. 5 and FIG. 6), and the disengaging part 58 of the retaining member 26 is configured to be extended into the carrying space S from the second opening 44 of the supporting member 22 (as shown in FIG. 8) . In order to allow the locking part 50 of the fastening member 24 and the disengaging part 58 of the retaining member 26 to cross over the carried object 10 during such process, the locking part 50 of the fastening member 24 and the disengaging part 58 of the retaining member 26 have guiding sections (such as being formed with inclined surfaces or curved surfaces), or the carried object 10 has a guiding section (such as being formed with an inclined surface or a curved surface), such that the locking part 50 of the fastening member 24 and the disengaging part 58 of the retaining member 26 can abut against the carried object 10 through the guiding section to cross over the carried object 10. Such configuration is well known to those skilled in the art, for simplification, no further illustration is provided.

When the carried object 10 is further moved longitudinally relative to the supporting member 22 along the retracting direction D1 to a predetermined position (such as a retracted position, but the present invention is not limited thereto) after the locking part 50 of the fastening member 24 and the disengaging part 58 of the retaining member 26 cross over the carried object 10, the locking part 50 of the fastening member 24 and the disengaging part 58 of the retaining member 26 correspond to the first stopping section 84 and the second stopping section 86 of the stopping feature 82 of the carried object 10 respectively (as shown in FIG. 15), so as to enable the first stopping mechanism R1 and the second stopping mechanism R2, such that the carried object 10 is in a stopping state and unable be longitudinally moved relative to the supporting member 22. As such, the carried object 10 is completely mounted to the rack to be in the stopping state (as shown in FIG. 14 and FIG. 15).

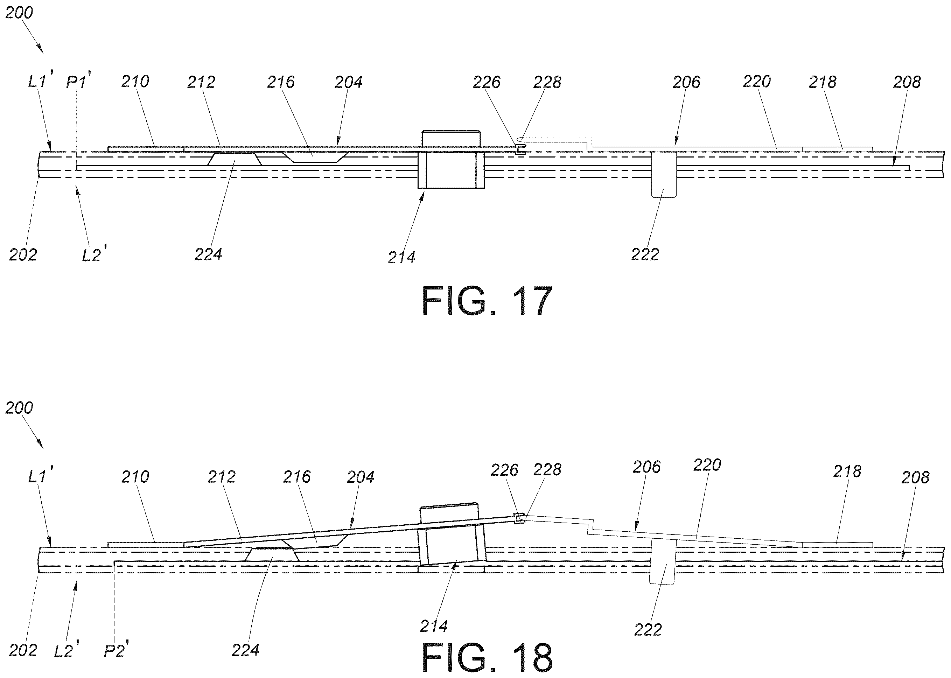

As shown in FIG. 17 and FIG. 18, a supporting device 200 according to a second embodiment of the present invention is provided. The supporting device 200 comprises a supporting member 202, a fastening member 204, a retaining member 206, and an operating member 208. The supporting member 202 has a first side L1' (such as an outer side) and a second side L2' (such as an inner side) opposite to the first side L1'. The fastening member 204 is arranged on the supporting member 202. For example, the fastening member 204 is arranged on the first side L1' of the supporting member 202. The fastening member 204 can be an elastic object (such as a spring sheet), but the present invention is not limited thereto. The fastening member 204 comprises a fixing part 210, an elastic part 212 extended from the fixing part 210, a locking part 214, and an abutting feature 216 adjacent to the locking part 214. The retaining member 206 is arranged on the supporting member 202. For example, the retaining member 206 is arranged on the first side L1' of the supporting member 202 and adjacent to the fastening member 204. The retaining member 206 can be an elastic object (such as a spring sheet), but the present invention is not limited thereto. The retaining member 206 comprises a connecting part 218, an elastic arm 220 extended from the connecting part 218, and a disengaging part 222. The operating member 208 comprises a guiding part 224 and is operatively connected to the fastening member 204. The operating member 208 is movably arranged on the first side L1' of the supporting member 202. The operating member 208 can be an elongated body or a rod body having a predetermined longitudinal length.

The interactions between most components of the supporting device 200 of the second embodiment are similar or identical to those of the first embodiment. One substantial difference from the first embodiment is that the fastening member 204 and the retaining member 26 of the second embodiment are configured to be engaged with each other during operation of the operating member 208 in order to hold the operating member 208 and the fastening 204 in a holding state. For simplification, only the substantial difference is illustrated below.

In the second embodiment, the fastening member 204 further comprises an engaging feature 226 (e.g., the engaging feature 226 is formed with a groove or an opening) and the retaining member 206 further comprises a blocking part 228 (such as a stopping block or a protrusion block), but the present invention is not limited thereto. In the present embodiment, the engaging feature 226 can be arranged on one of the fastening member 204 and the retaining member 206, and the blocking part 228 can be arranged on the other of the fastening member 204 and the retaining member 206.

When the operating member 208 is operated to move from a first position P1' to a second position P2', the abutting feature 216 of the fastening member 204 and the guiding part 224 of the operating member 208 are configured to abut against each other, such that the locking part 214 of the fastening member 204 is configured to be moved outward to switch from a locking state to an unlocking state, and the elastic part 212 of the fastening member 204 is configured to accumulate an elastic force. Meanwhile, the engaging feature 226 of the fastening member 204 is configured to be engaged with the blocking part 76 of the retaining member 206 in order to temporarily hold the locking part 214 of the fastening member 204 in the unlocking state.

The fastening member 204 and the retaining member 206 are configured to be disengaged from each other by the disengaging part 222 of the retaining member 206. For example, by pushing or applying an external force to the disengaging part 222 of the retaining member 206, the fastening member 204 can be disengaged from the retaining member 206. As such, the operating member 208 is pushed by the elastic force of the elastic part 212 of the fastening member 204 through the abutting feature 216 to move to the first position P1' from the second position P2'. Meanwhile, the locking part 214 of the fastening 206 is moved to switch to the locking state from the unlocking state.

Therefore, the supporting device (20, 200) according to the embodiments of the present invention has the following technical features:
1. The fastening member (24, 204), the retaining member (26, 206), and the operating member (28, 208) are all arranged on the first side (L1, L1') of the supporting member (22, 202) without affecting the carrying space S defined by the second side (L2, L2') of the supporting member (22, 202) and the supporting part 40 (the supporting part and the carrying space of the second embodiment are not shown in figures), such that the carrying space S can be fully utilized to carry the carried object 10. Accordingly, space inside the carried object 10 for accommodating related electronic devices is not affected.
2. When the locking part (50, 214) of the fastening member (24, 204) of the supporting device (20, 200) is moved to switch from the locking state to the unlocking state, the locking part (50, 214) can be held in the unlocking state to allow the carried object 10 to move relative to the supporting member (22, 202) to be detached from the supporting member (22, 202). During the process of moving the carried object 10 relative to the supporting member (22, 202) to detach the carried object 10 from the supporting member (22, 202), the locking part (50, 214) of the fastening member (24, 204) of the supporting device (20, 200) can return to the locking state from the unlocking state. In addition, when the carried object 10 is in the stopping state, the carried object 10 is configured to be stopped by the locking part (50, 214) and the disengaging part (58, 222), in order to be stably held on the supporting device (20, 200).

## Claims

1. A supporting device (20, 200), comprising:
a supporting member (22, 202) having a first side and a second side opposite to the first side;
an fastening member (24, 204) arranged on the supporting member (22, 202), the fastening member (24, 204) comprising an elastic part (48, 212) and a locking part (50, 214), wherein the locking part (50, 214) is configured to be extended from the first side of the supporting member (22, 202) to be protruded relative to the second side of the supporting member (22, 202) in response to an elastic force provided by the elastic part (48, 212) in order to be in a locking state;
an operating member (28, 208) operatively connected to the fastening member (24, 204); and
a retaining member (26, 206) arranged on the supporting member (22, 202);
**characterized in that**:
wherein when the operating member (28, 208) is operated to move from a first position to a second position relative to the supporting member (22, 202), the locking part (50, 214) of the fastening member (24, 204) is configured to be moved from the second side of the supporting member (22, 202) toward the first side of the supporting member (22, 202) to switch from the locking state to an unlocking state, and the retaining member (26, 206) is configured to be detachably engaged with one of the fastening member (24, 204) and the operating member (28, 208) in order to hold the locking part (50, 214) of the fastening member (24, 204) in the unlocking state.

2. The supporting device of claim 1, further **characterized by** a blocking part (76, 228) arranged on one of the retaining member (26, 206) and the operating member (28, 208), and an engaging feature (78, 226) arranged on the other one of the retaining member (26, 206) and the operating member (28, 208); wherein when the operating member (28, 208) is located at the second position, the blocking part (76, 228) is configured to be engaged with the engaging feature (78, 226) in order to hold the locking part (50, 214) of the fastening member (24, 204) in the unlocking state.

3. The supporting device of claim 2, **characterized in that** the operating member (28, 208) comprises a guiding part (70, 224), and the fastening member (24, 204) comprises an abutting feature (52, 216); wherein when the operating member (28, 208) is located at the second position, the guiding part (70, 224) of the operating member (28, 208) is configured to abut against the abutting feature (52, 216) of the fastening member (24, 204) to move the locking part (50, 214) of the fastening member (24, 204) to switch from the locking state to the unlocking state, and the elastic part (48, 212) of the fastening member (24, 204) is configured to accumulate the elastic force.

4. The supporting device of claim 3, **characterized in that** the retaining member (26, 206) comprises a disengaging part (58, 222) configured to be extended from the first side of the supporting member (22, 202) to be protruded relative to the second side of the supporting member (22, 202).

5. The supporting device of claim 4, **characterized in that** when the blocking part (76, 228) is disengaged from the engaging feature (78, 226), the elastic part (48, 212) of the fastening member (24, 204) is configured to release the elastic force to push the guiding part (70, 224) of the operating member (28, 208) through the abutting feature (52, 216), such that the operating member (28, 208) is moved to the first position from the second position.

6. The supporting device of claim 5, **characterized in that** the operating member (28, 208) comprises a front end part and a rear end part, the front end part is arranged with an operating part (72), and the rear end part is arranged with the guiding part (70, 224) .

7. The supporting device of any of claims 1-6, **characterized in that** the supporting member (22, 202) is arranged with a supporting part (40) perpendicularly connected to the supporting member (22, 202); wherein the second side of the supporting member (22, 202) and the supporting part (40) together define a carrying space and are configured to carry a carried object (10).

8. The supporting device of claim 6, **characterized in that** the guiding part (70, 224) of the operating member (28, 208) comprises at least one guiding section (74), and the guiding section (74) of the operating member (28, 208) is formed with a curved surface or an inclined surface.

9. The supporting device of claim 4, **characterized in that** the supporting member (22, 202) is formed with a first opening (42) communicating the first side of the supporting member (22, 202) and the second side of the supporting member (22, 202) to allow the locking part (50, 214) of the fastening member (24, 204) to move through the first opening (42) of the supporting member (22, 202) to be protruded or retracted relative to the second side of the supporting member (22, 202).

10. The supporting device of claim 4, **characterized in that** the supporting member (22, 202) is further formed with a second opening (44) communicating the first side of the supporting member (22, 202) and the second side of the supporting member (22, 202) to allow the disengaging part (58, 222) of the retaining member (26, 206) to move through the second opening (44) of the supporting member (22, 202) to be protruded or retracted relative to the second side of the supporting member (22, 202).

11. The supporting device of claim 10, further **characterized by** a return elastic member (80); wherein when the blocking part (50, 214) is disengaged from the engaging feature (78, 226), the return elastic member (80) is configured to provide an elastic force to the operating member (28, 208) to drive the operating member (28, 208) to return to the first position from the second position.

12. The supporting device of claim 7, **characterized in that** the locking part (50, 214) is configured to be extended from the first side of the supporting member (22, 202) to be protruded relative to the second side of the supporting member (22, 202) to extend into the carrying space in response to the elastic force provided by the elastic part (48, 212) to be in the locking state; wherein the carried object (10) comprises a stopping feature (82), and when the locking part (50, 214) of the fastening member (24, 204) faces toward the stopping feature (82) of the carried object (10) and when the locking part (50, 214) of the fastening member (24, 204) is in the locking state, the locking part (50, 214) of the fastening member (24, 204) is extended toward the stopping feature (82) of the carried object (10) to form a first stopping mechanism.

13. The supporting device of claim 12, **characterized in that** when the operating member (28, 208) is operated to move from the first position to the second position relative to the supporting member (22, 202), the locking part (50, 214) of the fastening member (24, 204) is configured to be moved from the second side of the supporting member (22, 202) toward the first side of the supporting member (22, 202) to be moved away from the carrying space to switch from the locking state to the unlocking state to disable the first stopping mechanism, and the retaining member (26, 206) is configured to be detachably engaged with one of the fastening member (24, 204) and the operating member (28, 208) in order to hold the locking part (50, 214) of the fastening member (24, 204) in the unlocking state.

14. The supporting device of claim 13, **characterized in that** the retaining member (26, 206) comprises an disengaging part (58, 222) configured to extended from the first side of the supporting member (22, 202) to be protruded relative to the second side of the supporting member (22, 202) to extend into the carrying space; wherein when the locking part (50, 214) of the fastening member (24, 204) is extended toward the stopping feature (82) of the carried object (10) to form the first stopping mechanism, the disengaging part (58, 222) of the retaining member (26, 206) is configured to be extended toward the stopping feature (82) of the carried object (10) to form a second stopping mechanism.

15. The supporting device of claim 14, **characterized in that** the stopping feature (82) of the carried object (10) comprises a first stopping section (84) and a second stopping section (86); wherein when the first stopping mechanism is enabled, the locking part (50, 214) of the fastening member (24, 204) and the first stopping section (84) of the stopping feature (82) of the carried object (10) are configured to block each other; wherein when the second stopping mechanism is enabled, the disengaging part (58, 222) of the retaining member (26, 206) and the second stopping section (86) of the stopping feature (82) of the carried object (10) are configured to block each other.
